# EUROPEAN PATENT SPECIFICATION

(11) **EP 1 093 149 B1**
(45) Date of publication and mention of the grant of the patent: **07.12.2011**
(21) Application number: 00308816.8
(22) Date of filing: 06.10.2000
(51) Int. Cl.: H01J 27/08

(54) **Ionizer for an ion implanter, ion source comprising this ionizer and method of cooling an ionizer**
Ionisator, Ionenquelle mit einem solchen Ionisator und Verfahren zur Kühlung eines Ionisators
Ionisateur, source d'ions comprenant cet ionisateur et procédé de refroidir un ionisateur

(30) Priority: 11.10.1999 US 416159
(43) Date of publication of application: 18.04.2001
(73) Proprietor: Axcelis Technologies, Inc., Beverly, MA 01915-1053 (US)
(72) Inventor: Horsky, Thomas Neil, Boxborough, Massachusetts 01719 (US); Perel, Alexander Stuart, Danvers, Massachusetts 01923 (US); Loizides, William Keith, Hollis, New Hampshire 03049 (US)
(74) Representative: Treeby, Philip David William

(56) References cited:
- EP-A- 0 954 008
- US-A- 3 700 892
- US-A- 5 661 308
- TAKEUCHI D ET AL: "Shallow junction formation by polyatomic cluster ion implantation" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, vol. 121, no. 1, 1997, pages 345-348, XP004057939 ISSN: 0168-583X

## Description

### Field of the Invention

The present invention relates generally to ion sources for ion implantation equipment and more specifically to an ion source for ionizing decaborane and to a method of cooling an ionizer.

### Background of the Invention

Ion implantation has become a standard accepted technology of industry to dope workpieces such as silicon wafers or glass substrates with impurities in the large scale manufacture of items such as integrated circuits and flat panel displays. Conventional ion implantation systems include an ion source that ionizes a desired dopant element which is then accelerated to form an ion beam of prescribed energy. The ion beam is directed at the surface of the workpiece to implant the workpiece with the dopant element. The energetic ions of the ion beam penetrate the surface of the workpiece so that they are embedded into the crystalline lattice of the workpiece material to form a region of desired conductivity. The implantation process is typically performed in a high vacuum process chamber which prevents dispersion of the ion beam by collisions with residual gas molecules and which minimizes the risk of contamination of the workpiece by airborne particulates.

Ion dose and energy are the two most important variables used to define an implant step. Ion dose relates to the concentration of implanted ions for a given semiconductor material. Typically, high current implanters (generally greater than 10 milliamps (mA) ion beam current) are used for high dose implants, while medium current implanters (generally capable up to about 1 mA beam current) are used for lower dose applications. Ion energy is used to control junction depth in semiconductor devices. The energy of the ions which make up the ion beam determine the degree of depth of the implanted ions. High energy processes such as those used to form retrograde wells in semiconductor devices require implants of up to a few million electron volts (MeV), while shallow junctions may only demand energies below 1 thousand electron volts (keV).

The continuing trend to smaller and smaller semiconductor devices requires implanters with ion sources that serve to deliver high beam currents at low energies. The high beam current provides the necessary dosage levels, while the low energy levels permit shallow implants. Source/drain junctions in complementary metal-oxide-semiconductor (CMOS) devices, for example, require such a high current, low energy application.

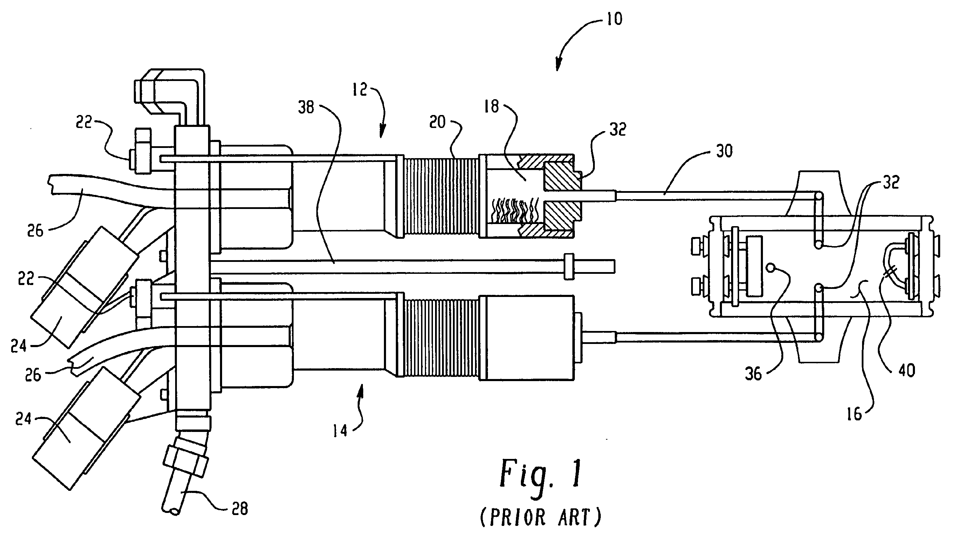

A typical ion source 10 for obtaining atoms for ionization from a solid form is shown in Figure 1. The ion source comprises a pair of vaporizers 12 and 14 and an ionization chamber 16. Each of the vaporizers is provided with a crucible 18 in which a solid element or compound is placed and which is heated by a heater coil 20 to vaporize the solid source material. Heater coil leads 22 conduct electrical current to the heater coils and thermocouples 24 provide a temperature feedback mechanism. Air cooling conduit 26 and water-cooling conduit 28 is also provided.

Vaporized source material passes through a nozzle 30, which is secured to the crucible 18 by a graphite nozzle retainer 32, and through vaporizer inlets 34 to the interior of the ionization chamber 16. Alternatively, compressed gas may be fed directly into the ionization chamber by means of a gas inlet 36 via a gas line 38. In either case, the gaseous/vaporized source material is ionized by an arc chamber filament 40 that is heated to thermionically emit electrons.

Conventional ion sources utilize an ionizable dopant gas which is obtained either directly from a source of a compressed gas or indirectly from a solid which has been vaporized. Typical source elements are boron (B), phosphorous (P), gallium (Ga), indium (In), antimony (Sb), and arsenic (As). Most of these source elements are commonly used in both solid and gaseous form, except boron, which is almost exclusively provided in gaseous form, *e.g.*, as boron trifluoride (BF₃).

In the case of implanting boron trifluoride, a plasma is created which includes singly charged boron (B+) ions. Creating and implanting a sufficiently high dose of boron into a substrate is usually not problematic if the energy level of the beam is not a factor. In low energy applications, however, the beam of boron ions will suffer from a condition known as "beam blow-up", which refers to the tendency for like-charged ions within the ion beam to mutually repel each other. Such mutual repulsion causes the ion beam to expand in diameter during transport, resulting in vignetting of the beam by multiple apertures in the beamline. This severely reduces beam transmission as beam energy is reduced.

Decaborane (B₁₀H₁₄) is a compound which is an excellent source of feed material for boron implants because each decaborane molecule (B₁₀H₁₄) when vaporized and ionized can provide a molecular ion comprised often boron atoms. Such a source is especially suitable for high dose/low energy implant processes used to create shallow junctions, because a molecular decaborane ion beam can implant ten times the boron dose per unit of current as can a monatomic boron ion beam. In addition, because the decaborane molecule breaks up into individual boron atoms of roughly one-tenth the original beam energy at the workpiece surface, the beam can be transported at ten times the energy of a dose-equivalent monatomic boron ion beam. This feature enables the molecular ion beam to avoid the transmission losses that are typically brought about by low energy ion beam transport.

However, decaborane ion sources to date have been unsuccessful at generating sufficient ion beam current for production applications of boron implants. Known hot-cathode sources are unsuitable for decaborane ionization because the heat generated by the cathode and arc in turn heats the walls and components to greater than 500°C, causing dissociation of the decaborane molecule into borane fragments and elemental boron. Known plasma-based sources are unsuitable for decaborane ionization because the plasma itself can cause dissociation of the decaborane molecule and fragmentation of the B₁₀Hₓ⁺ desired parent ion. Accordingly, in known decaborane ion sources, the source chamber pressure is kept sufficiently low to prevent the sustenance of a local plasma. Thus far, ion beam currents developed from such a source are too low for production applications.

Accordingly, it is an object of the present invention to provide an ion source for an ion implanter, which can accurately and controllably ionize sufficient decaborane to produce acceptable production ion beam current levels, to overcome the deficiencies of known ion sources.

US 3 700 892 discloses an apparatus for the electromagnetic separation of the isotopes of mercury consists of a reservoir containing elemental mercury for placement within the ion source of the apparatus wherein the reservoir is enveloped in heating coils adapted for liquid flow therein and the assemblage is further enclosed in a soft-solder-filled outer shell of good thermal conductivity. Improved isotopic separations result from the thermal stabilization provided by the liquid flow in the heating coils as it removes spurious heat from the ion source and imparts the desired heat to the mercury charge material in the reservoir.

EP 0 954 008 discloses an ion source for an ion implanter comprising: (i) a sublimator having a cavity for receiving a source material to be sublimated and for sublimating the source material; (ii) an ionization chamber for ionizing the sublimated source material, the ionization chamber located remotely from the sublimator; (iii) a tube for connecting the sublimator to the ionization chamber; and (iv) a heating medium for heating at least a portion of the sublimator and the tube. A control mechanism is provided for controlling the temperature of the heating medium. The control mechanism comprises a heating element for heating the heating medium, a pump for circulating the heating medium, at least one thermocouple for providing temperature feedback from the heating medium, and a controller - responsive to the temperature feedback to output a first control signal to the heating element.

The paper, 'Shallow junction formation by polyatomic cluster ion implantation' by D Takeuchi et al shows a schematic of a decaborane implanter.

### Summary of the Invention

According to the present invention there is provided an ioniser as claimed in claim 1 and a method as claimed in claim 14.

The ionizer comprises a body having an inlet for receiving the vaporized decaborane; an ionization chamber in which the vaporized decaborane may be ionized by an energy-emitting element to create a plasma; and an exit aperture for extracting an ion beam comprised of the plasma. A cooling mechanism is provided for lowering the temperature of walls of the ionization chamber (e.g., to below 350°C) during the ionization of the vaporized decaborane to prevent dissociation of vaporized decaborane molecules into atomic boron ions. In addition, the energy-emitting element is operated at a sufficiently low power level to minimize plasma density within the ionization chamber to prevent additional dissociation of the vaporized decaborane molecules by the plasma itself.

In order that the present invention be more readily understood, specific embodiments thereof will now be described.

### Brief Description of the Drawings

Figure 1 is a perspective, partially cross sectional view of a conventional ion source for an ion implanter;
Figure 2 is a schematic, partially cross sectional view of a first embodiment of an ion source for an ion implanter constructed according to the principles of the present invention;
Figure 3 is a cross sectional view of a connecting tube of an alternative embodiment of the ion source of Figure 2, taken along the lines 3-3; and
Figure 4 is a partially cross sectional view of the ionizer portion of the ion source of Figure 2.

### Detailed Description of a Preferred Embodiment of the Invention

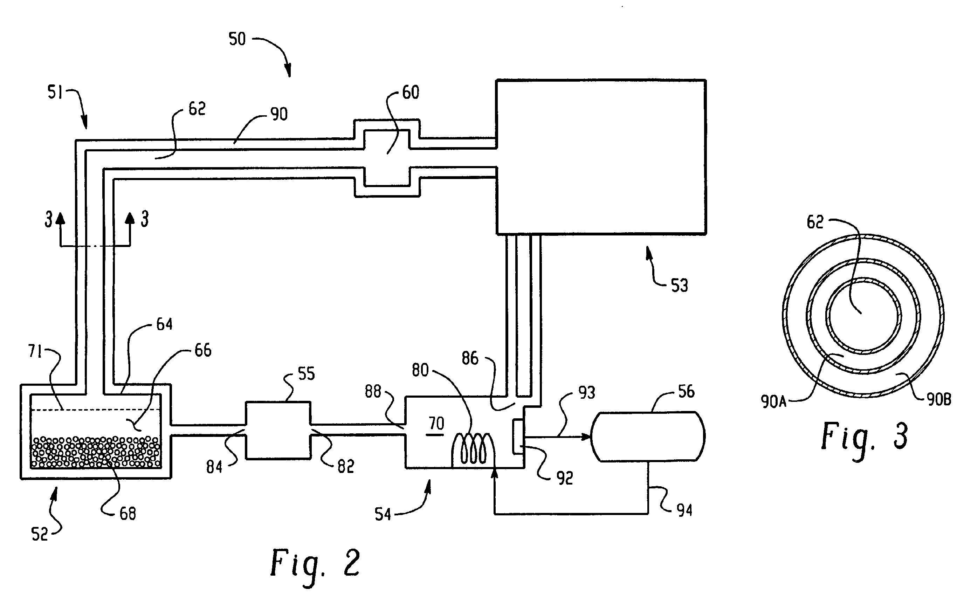

Referring now to Figures 2-4 of the drawings, and initially to Figure 2, an ion source 50 comprising a vaporizer 51 and an ionizer 53 are shown, constructed according to the present invention. The vaporizer 51 comprises a non-reactive, thermally conductive sublimator or crucible 52, a heating medium reservoir 54, a heating medium pump 55, a temperature controller 56, and a mass flow controller 60. Ionizer 53 is shown in more detail in Figure 3. The crucible 52 is located remotely from the ionizer 53 and connected thereto by a feed tube 62, constructed of quartz or stainless steel. In the disclosed embodiment, the feed tube 62 is surrounded by an outer single-chamber annular sheath 90 along substantially the entire length thereof.

The crucible 52 provides a container 64 enclosing a cavity 66 for containing a source material 68. The container is preferably made of a suitable non-reactive (inert) material such as stainless steel, graphite, quartz or boron nitride and which is capable of holding a sufficient amount of source material such as decaborane (B₁₀H₁₄). Although the invention as claimed is described further below only in terms of decaborane, it is contemplated that the principles of the present invention may be used for other molecular solid source materials, such as indium trichloride (InCl₃), which are characterized as having both low melting points (i.e., sublimation temperatures of between 20°C and 250°C) and significant room temperature vapor pressures (i.e. between 133⁻² Pa and 133³ Pa (10⁻² Torr and 10³ Torr)).

The decaborane is vaporized through a process of sublimation by heating the walls of the container 64 with a heating medium 70 contained in reservoir 54. A wire mesh 71 prevents non-vaporized decaborane from escaping the crucible 52. Completely vaporized decaborane exits the crucible 52 via feed tube 62 and enters mass flow controller 60, which controls the flow of vapor, and thus meters the amount of vaporized decaborane which is provided to the ionizer 53, as is known in the art.

Alternatively, in a second embodiment of the invention, the feed tube 62 is provided in the form of a capillary tube and sheath 90 is provided in the form of a coaxial dual-chamber sheath, comprising an inner sheath 90A surrounded by an outer sheath 90B (see Figure 3). The heating medium may be pumped into the inner sheath 90A (located adjacent the capillary tube 62) and pumped out of the outer sheath 90B (located radially outward from the inner sheath 90A). In this second embodiment, the mass flow controller 60 is replaced with a heated shut-off valve (not shown) located at the feed tube/ionizer interface, and mass flow is increased or decreased by directly changing the temperature of the reservoir 54. Alternatively, a separate heat source may be provided for the shut-off valve. The arrangement of the coaxial sheath surrounding the capillary tube has the advantage of providing an insulating sheath surrounding the inner diameter of the capillary tube, thereby resulting in a more uniform temperature.

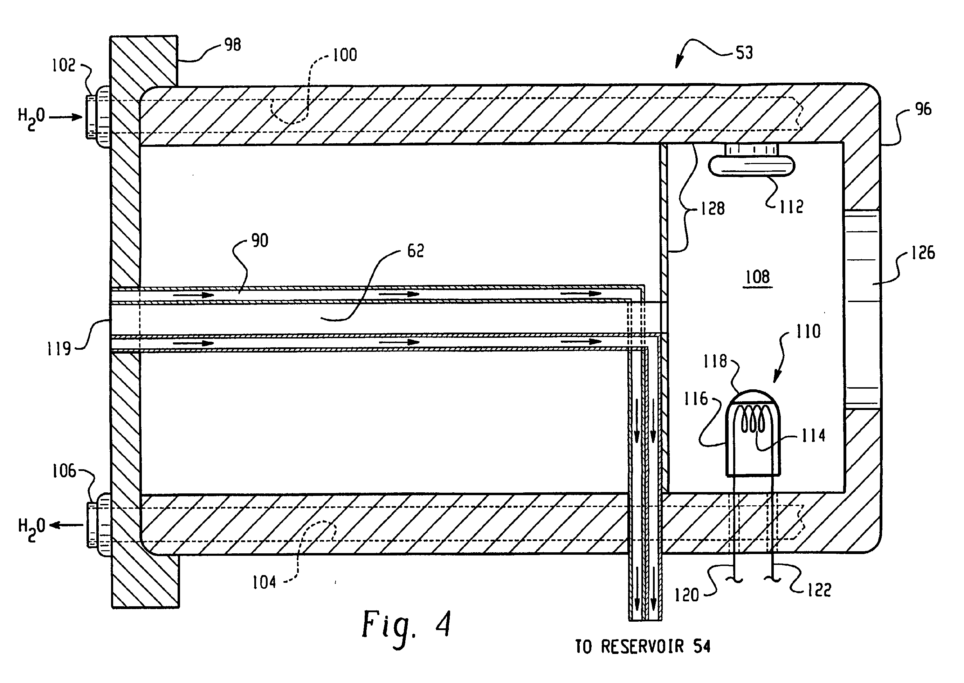

The ionizer 53 is shown in more detail in Figure 4. The ionizer 53 comprises a generally cylindrical body 96 and a generally annular base or mounting flange 98, both in the preferred embodiment constructed of aluminium. Aluminium does not pose significant contamination problems. The body 96 is preferably constructed of a single machined piece of aluminium to facilitate water cooling as described below. In addition, aluminium provides good thermal conductivity.

The aluminium body 96 is cooled by means of entry cooling passageway 100 fed by inlet 102 and exit cooling passageway 104 which exits body 96 via outlet 106. The cooling medium may be water or any other suitable fluid having high heat capacity. The entry and exit cooling passageways provide a continuous pathway by which water flows therethrough to cool the ionizer body 96. Although only a fragmented portion of the pathway is shown in phantom in Figure 4, the pathway may extend near and about the outer periphery of the body in any known configuration to insure that the entire body is effectively cooled. By cooling the body 96, an ionization chamber 108 within the ionizer 53 may be maintained at a temperature low enough (less than 350° C) to prevent dissociation of the ionized decaborane molecule.

Within the confines of the ionizer body 96 are an extension of the feed tube 62, surrounded by annular sheath 90, terminating at ionization chamber 108. Within the ionization chamber reside a hot cathode 110 and an anti-cathode or repeller 112. The hot cathode 110 comprises a heated filament 114 surrounded by a cylinder 116 and capped by endcap 118. In the preferred embodiment, the filament and the endcap are made of tungsten, and the cylinder is made of molybdenum. The heated filament 114 is energized via power feedthroughs 120 and 122 that pass through and are electrically insulated from the aluminum body 96. The repeller 112 is also electrically insulated from the body 96, via a thermally conductive electrically insulating material (such as sapphire) which physically couples the repeller to the cooled ionization chamber 108.

In operation, the vaporized material is injected into the ionization chamber via feed tube 62 at ionizer inlet 119. When the tungsten filament 114 is energized electrically by application of a potential difference across feedthroughs 120 and 122, the filament emits electrons that accelerate toward and impact endcap 118. When the endcap 118 is sufficiently heated by electron bombardment, it in turn emits electrons into the ionization chamber 108 that strike the vaporized gas molecules to create ions in the chamber.

A low-density ion plasma is thereby created, from which an ion beam is extracted from the chamber through source aperture 126. The low density of the plasma in chamber 108 is in part provided by the relatively low arc discharge power maintained in the source (about 5 watts (W) at 50 milliamps (mA)). The endcap 118 shields the filament 114 from contact with the low-density plasma and thereby extends the lifetime of the filament. The indirectly heated cathode arrangement shown in Figure 4 may be replaced by other conventional source devices, for example simple filaments as used in Freeman-type or Bernas-type ion sources.

Electrons generated by cathode 110 which do not strike a decaborane molecule in the ionization chamber to create a decaborane ion move toward the repeller 112, which deflects these electrons back toward the cathode. The repeller is preferably constructed of molybdenum and, like the cathode, is electrically insulated from the ionizer body 96. The repeller may be water-cooled if it is found that minimal decaborane molecule dissociation is being caused by the repeller (or physically coupled to the body 96 using an electrical insulator with high thermal conductivity).

Walls 128 of the ionization chamber 108 are maintained at local electrical ground potential. The cathode 110, including endcap 118, is maintained at a potential of approximately 50 to 150 volts below the potential of the walls 128. The filament 114 is maintained at a voltage approximately between 200 and 600 volts below the potential of the endcap 118. The large voltage difference between the filament 114 and the endcap 118 imparts a high energy to the electrons emitted from the filament to sufficiently heat endcap 118 to thermionically emit electrons into the ionization chamber 108.

Alternatively, instead of the cathode/repeller combination shown in Figure 4, an RF exciter (not shown) such as an antenna may be energized to emit an RF signal that ionizes the vaporized decaborane molecules in the chamber 108 to create a plasma. The power associated with such an RF antenna is on the order of 40W-50W. A magnetic filter (not shown) also disposed within the chamber 108 filters the plasma, and extractor electrodes (not shown) located outside source aperture 126 extract the plasma from the ionization chamber as is known in the art. Alternatively still, microwave energy may be directed from a microwave source to the ionization chamber 108 to ionize the vaporized decaborane molecules to create a plasma.

The inventive ion source 50 provides a control mechanism for controlling the operating temperature of the crucible 52, as well as that of the feed tube 62 through which vaporized decaborane passes on its way to and through the ionizer 53. The heating medium 70 is heated within the reservoir 54 by a resistive or similar heating element 80 and cooled by a heat exchanger. The temperature control means comprises a temperature controller 56 which obtains as an input temperature feedback from the reservoir 54 via thermocouple 92, and outputs a control signal to heating element 80, as further described below, so that the heating medium 70 in the reservoir is heated to a suitable temperature. The operating temperature control mechanism for heating both the vaporizer 51 and the feed tube in the ionizer 53 may be provided by a single circuit, as shown in Figures 2 and 4. Alternatively, separate temperature control circuits may be provided for the vaporizer 51 and the ionizer 53.

The heating medium 70 comprises mineral oil or other suitable medium (e.g. water) that provides a high heat capacity. The oil is heated to a temperature within the 20°C to 250°C range by the heating element 80 and circulated by pump 55 around the crucible 52 and the feed tube 62 through sheath 90. The pump 55 is provided with an inlet and an outlet 82 and 84, respectively, and the reservoir 54 is similarly provided with an inlet 86 and an outlet 88, respectively. The flow pattern of the heating medium about the crucible 52 and the feed tube 62, although shown in a unidirectional clockwise pattern in Figure 2, may be any pattern that provides reasonable circulation of the medium about the crucible 52 and the feed tube 62.

Referring back to Figure 2, the crucible cavity 66 is pressurized in order to facilitate material transfer of the vaporized (sublimated) decaborane from the crucible 52 to the ionization chamber 108 through the feed tube 62. As the pressure within cavity 66 is raised, the rate of material transfer correspondingly increases. The ionization chamber operates at a near vacuum (about 1 millitorr), and thus, a pressure gradient exists along the entire length of the feed tube 62, from the crucible 52 to the ionization chamber 108. The pressure of the crucible is typically on the order of 133 Pa (1 torr).

By locating the crucible 52 remotely from the ionization chamber 108, the material within crucible cavity 66 is thermally isolated, thereby providing a thermally stable environment unaffected by the temperature in the ionization chamber. As such, the temperature of the crucible cavity 66, in which the process of decaborane sublimation occurs, may be controlled independently of the operating temperature of the ionization chamber 108 to a high degree of accuracy (within 1° C). Also, by maintaining a constant temperature of the vaporized decaborane during transport to the ionization chamber via the heated feed tube 62, no condensation or thermal decomposition of the vapor occurs.

The temperature controller 56 controls the temperature of the crucible 52 and the feed tube 62 by controlling the operation of the heating element 80 for the heating medium reservoir 70. Thermocouple 92 senses the temperature of the reservoir 70 and sends temperature feedback signal 93 to the temperature controller 56. The temperature controller responds to this input feedback signal in a known manner by outputting control signal 94 to the reservoir heating element 80. In this manner, a uniform temperature is provided for all surfaces to which the solid phase decaborane and vaporized decaborane are exposed, up to the location of the ionization chamber.

By controlling the circulation of the heating medium in the system (via pump 55) and the temperature of the heating medium (via heating element 80), the ion source 50 can be controlled to an operating temperature of on the order of 20° C to 250° C (+/- 1° C). Precise temperature control is more critical at the crucible, as compared to the end of the feed tube nearest the ionization chamber, to control the pressure of the crucible and thus the vapor flow rates out of the crucible.

Because the plasma density using the inventive source is kept low (on the order 10¹⁰/cm³) to prevent dissociation of the decaborane molecule, total extracted ion beam current will be low when using a conventionally-sized source aperture. Assuming a comparable beam current density, the aperture 126 in the ionizer 53 of the present invention is made large enough to insure an adequate ion beam current output. A 1cm² (.22 cm X 4.5 cm) aperture permits a beam current density of about 100 microamps per square centimeter (µA/cm²) at the workpiece (i.e. 1 µA), and up to (less than or equal to) 1 mA/cm² of extracted beam current from the source (i.e., 1 mA). (The actual focused beam current delivered to the workpiece is only a fraction of the total extracted beam current.) Aperture sizes of about 5 cm² are possible in some implanters, which would yield a B₁₀Hₓ⁺ beam current of about 500 µA at the workpiece. In ultra low energy (ULE) implanters, even larger aperture sizes (up to 13 cm²) are possible.

Using either embodiment of the source 50 of Figure 2 in an ion implanter, an entire molecule (ten boron atoms) is implanted into the workpiece. The molecule breaks up at the workpiece surface such that the energy of each boron atom is roughly one-tenth the energy of the ten-boron cluster (in the case of B₁₀H₁₄). Thus, the beam can be transported at ten times the desired boron implantation energy, enabling very shallow implants without significant beam transmission losses. In addition, at a given beam current, each unit of current delivers ten times the dose to the workpiece. Finally, because the charge per unit dose is one-tenth that of a monatomic beam implant, workpiece charging problems are much less severe for a given dose rate.

Accordingly, a preferred embodiment of an improved ion source for an ion implanter has been described. With the foregoing description in mind, however, it is understood that this description is made only by way of example, that the invention is not limited to the particular embodiments described herein, and that various rearrangements, modifications, and substitutions may be implemented with respect to the foregoing description without departing from the scope of the invention as defined by the following claims.

## Claims

1. An ionizer (53) for an ion implanter, comprising:
a body (96) having an inlet (119) to a feed tube (62) for receiving a vaporized source material, said feed tube (62) provided with a heating mechanism (90) operable to heat the vaporized source material as it passes through the body (96);
an ionization chamber (108) in which the vaporized source material may be ionized by an electron-emitting element (110) to create a plasma;
an exit aperture (126) for extracting an ion beam comprised of said plasma; and
a cooling mechanism (100, 104) for lowering the temperature of walls (128) of said ionization chamber (108) during the ionization of said vaporized source material.

2. The ionizer (53) of claim 1, wherein said vaporized source material is vaporized decaborane.

3. The ionizer (53) of claim 2, wherein said body (96) is generally cylindrical in shape and constructed of aluminium.

4. The ionizer (53) of claim 2, wherein said cooling mechanism comprises one or more passageways (100, 104) through which a cooling medium may be circulated.

5. The ionizer (53) of claim 2, wherein said cooling mechanism is operable to maintain said walls (128) of said ionization chamber (108) below 350 °C to prevent dissociation of vaporized decaborane molecules.

6. The ionizer (53) of claim 2, wherein said aperture (126) is sized between 1cm² and 13cm².

7. The ionizer (53) of claim 2, wherein said electron-emitting element (110) comprises a filament (114), the ionizer (53) being operable so that said filament (114) emits a first group of electrons that are accelerated toward an endcap (118) that in turn emits a second group of electrons which strike the vaporized decaborane in said ionization chamber (108) to create the plasma, and wherein said ionizer further comprises a repeller (112) for repelling a portion of said second group of electrons back toward said electron-emitting element.

8. The ionizer (53) of claim 7, wherein said repeller (112) is water-cooled.

9. The ionizer (53) of claim 7, wherein the arc discharge between the endcap (118) and the ionization chamber wall (128) is operable to operate at a power level of approximately 5 watts (W) and at an electrical current level of about 50 milliamps (mA).

10. An ion source (50) comprising:
(i) a vaporizer (51) having a cavity (66) for receiving a source material (68) to be vaporized and for vaporizing the source material;
(ii) an ionizer (53) according to any of claims 1 to 7; and
(iii) a heating medium (70) for heating at least a portion of said vaporizer (51) and said feed tube (62).

11. The ion source (50) of claim 10, further comprising a control mechanism for controlling the temperature of said heating medium (70).

12. The ion source (50) of claim 10, wherein said energy-emitting element is a radio frequency (RF) exciter.

13. The ion source (50) of claim 10, wherein said energy-emitting element is a microwave source.

14. A method of cooling an ionizer for an implanter said ionizer comprising:
a body (96) having an inlet (119) to a feed tube (62) for receiving a vaporized source material, said feed tube (62) provided with a heating mechanism (90) operable to heat the vaporized source material as it passes through the body (96);
an ionization chamber (108) in which the vaporized source material is ionized by an electron-emitting element (110) to create a plasma;
an exit aperture (126) for extracting an ion beam comprised of said plasma; and
a cooling mechanism (100, 104) for lowering the temperature of walls (128) of said ionization chamber (108) during the ionization of said vaporized material, said method comprising the steps of:
circulating coolant around the walls of the ionization chamber during ionization of the vaporized material.

15. The method of claim 14, wherein said cooling mechanism maintains said walls (128) of said ionization chamber (108) below 350 °C to prevent dissociation of vaporized decaborane molecules.

16. The method of claim 14, wherein said aperture (126) is sized to provide a focused ion beam current of between 100-500 microamps (mu A) at a beam current density of < 1 milliamp per square centimetre (mA/cm²).

17. The method of claim 14, wherein said plasma has a density within said chamber (108) on the order of 10¹⁰/cm³.

## Patentansprüche

1. Ionisator (53) für einen Ionenimplantierer, umfassend:
einen Körper (96), der einen Einlass (119) in eine Zuführröhre (62) zum Aufnehmen eines verdampften Quellenmaterials aufweist, wobei die Zuführröhre (62) mit einem Erhitzungsmechanismus (90) ausgestattet ist,
der funktionsfähig ist, das verdampfte Quellenmaterial zu erhitzen, während es durch den Körper (96) hindurchgeht;
eine Ionisationskammer (108) in der das verdampfte Quellenmaterial durch ein Elektronen emittierendes Element (110) ionisiert werden kann, um ein Plasma zu bilden;
eine Auslassöffnung (126) zum Extrahieren eines Ionenstrahls, der aus dem Plasma besteht; und
einen Kühlmechanismus (100, 104) zum Reduzieren der Temperatur der Wände (128) der Ionisationskammer (108) während des Ionisierens des verdampften Quellenmaterials.

2. Ionisator (53) nach Anspruch 1, wobei das verdampfte Quellenmaterial verdampftes Decaboran ist.

3. Ionisator (53) nach Anspruch 2, wobei der Körper (96) allgemein zylindrischer Gestalt ist und aus Aluminium besteht.

4. Ionisator (53) nach Anspruch 2, wobei der Kühlmechanismus einen oder mehrere Durchgänge (100, 104) umfasst, durch die ein Kühlmedium zirkuliert werden kann.

5. Ionisator (53) nach Anspruch 2, wobei der Kühlmechanismus funktionsfähig ist, die Wände (128) der Ionisationskammer (108) bei unter 350 °C zu halten, um die Dissoziation verdampfter Decaboranmoleküle zu verhindern.

6. Ionisator (53) nach Anspruch 2, wobei die Öffnung (126) eine Größe zwischen 1 cm² und 13 cm² aufweist.

7. Ionisator (53) nach Anspruch 2, wobei das Elektronen emittierende Element (110) ein Filament (114) umfasst, wobei der Ionisator (53) funktionsfähig ist, so dass das Filament (114) eine erste Gruppe von Elektronen emittiert, die auf eine Endkappe (118) zu beschleunigt werden, die wiederum eine zweite Gruppe von Elektronen emittiert, die auf das verdampfte Decaboran in der Ionisationskammer (108) auftreffen, um das Plasma zu bilden, und wobei der Ionisator des Weiteren einen Abweiser (112) zum Abweisen eines Teils der zweiten Gruppe von Elektronen zurück auf das Elektronen emittierende Element zu umfasst.

8. Ionisator (53) nach Anspruch 7, wobei der Abweiser (112) wassergekühlt ist.

9. Ionisator (53) nach Anspruch 7, wobei die Bogenentladung zwischen der Endkappe (118) und der Ionisationskammerwand (128) funktionsfähig ist, um bei einem Energieniveau von etwa 5 Watt (W) und einem elektrischen Stromniveau von etwas 50 Milliampere (mA) zu funktionieren.

10. Ionenquelle (40) umfassend:
(i) einen Verdampfer (51), der einen Hohlraum (66) zum Aufnehmen eines Quellenmaterials (68), das verdampft werden soll und zum Verdampfen des Quellenmaterials aufweist;
(ii) einen Ionisator (53) nach einem der Ansprüche 1 bis 7; und
(iii) ein Erhitzungsmedium (70) zum Erhitzen mindestens eines Teils des Verdampfers (51) und der Zuführröhre (62).

11. Ionenquelle (50) nach Anspruch 10, des Weiteren einen Regelmechanismus zum Regeln der Temperatur des Erhitzungsmediums (70) umfassend.

12. Ionenquelle (50) nach Anspruch 10, wobei das Energie emittierende Element ein Radiofrequenz- (RF-) Erreger ist.

13. Ionenquelle (50) nach Anspruch 10, wobei das Energie emittierende Element eine Mikrowellenquelle ist.

14. Verfahren zum Kühlen eines Ionisators für einen Implantierer, wobei der Ionisator Folgendes umfasst:
einen Körper (96), der einen Einlass (119) in eine Zuführröhre (62) zum Aufnehmen eines verdampften Quellenmaterials umfasst, wobei die Zuführröhre (62) mit einem Erhitzungsmechanismus (90) ausgestattet ist,
der funktionsfähig ist, das verdampfte Quellenmaterial zu erhitzen, während es durch den Körper (96) hindurchgeht;
eine Ionisationskammer (108), in der das verdampfte Quellenmaterial durch ein Elektronen emittierendes Element (110) ionisiert wird, um ein Plasma zu bilden;
eine Auslassöffnung (126) zum Extrahieren eines Ionenstrahls, der aus dem Plasma besteht; und
einen Kühlmechanismus (100, 104) zum Reduzieren der Temperatur der Wände (128) der Ionisationskammer (108) während des Ionisierens des verdampften Quellenmaterials, wobei das verfahren die Schritte umfasst des:
Zirkulierens des Kühlmittels um die Wände der Ionisationskammer während des Ionisierens des verdampften Materials.

15. Verfahren nach Anspruch 14, wobei der Kühlmechanismus die Wände (128) der Ionisationskammer (108) bei unter 350 °C hält, um die Dissoziation der verdampften Decaboranmoleküle zu verhindern.

16. Verfahren nach Anspruch 14, wobei die Öffnung (126) so dimensioniert ist, dass sie einen fokussierten Ionenstrahlstrom zwischen 100 500 Mikroampere (mu A) bei einer Strahlstromdichte von < 1 Milliampere pro Quadratzentimeter (mA/cm²) bereitstellt.

17. Verfahren nach Anspruch 14, wobei das Plasma eine Dichte innerhalb der Kammer (108) einer Größenordnung von 10¹⁰/cm³ aufweist.

## Revendications

1. Ioniseur (53) pour implanter ionique, comprenant :
➢ un corps (96) comportant une entrée (719) vers un tube d'alimentation (62) afin de recevoir un matériau source vaporisé, ledit tube d'alimentation (62) étant doté d'un mécanisme de chauffage (90) permettant de chauffer le matériau source vaporisé lors de son passage à travers le corps (96) ;
➢ une chambre d'ionisation (108) dans laquelle le matériau source vaporisé peut être ionisé par un élément émetteur d'électrons (110) afin de créer un plasma ;
➢ une ouverture de sortie (126) pour extraire un faisceau d'ions composé dudit plasma ; et
➢ un mécanisme de refroidissement (100, 104) pour abaisser la température des parois (128) de ladite chambre d'ionisation (108) lors de l'ionisation dudit matériau source vaporisé.

2. Ioniseur (53) selon la revendication 1, dans lequel ledit matériau source vaporisé est du décaborane vaporisé.

3. Ioniseur (53) selon la revendication 2, dans lequel ledit corps (96) est de forme généralement cylindrique et est composé d'aluminium.

4. Ioniseur (53) selon la revendication 2, dans lequel ledit mécanisme de refroidissement comprend une ou plusieurs voies de passage (100, 104) à travers lesquelles un milieu de refroidissement peut être mis en circulation.

5. Ioniseur (53) selon la revendication 2, dans lequel ledit mécanisme de refroidissement permet de maintenir lesdites parois (128) de ladite chambre d'ionisation (108) en dessous de 350 °C pour éviter la dissociation des molécules de décaborane vaporisé.

6. Ioniseur (53) selon la revendication 2, dans lequel la taille de ladite ouverture (126) est comprise entre 1 cm² et 13 cm².

7. Ioniseur (53) selon la revendication 2, dans lequel ledit élément émetteur d'électrons (110) comprend un filament (114) qui, lors du fonctionnement de l'ioniseur (53), émet un premier groupe d'électrons qui sont accélérés en direction d'un bouchon (118) qui à son tour émet un second groupe d'électrons qui frappent le décaborane vaporisé dans ladite chambre d'ionisation (108) pour créer le plasma, et dans lequel ledit ioniseur comprend en outre un réflecteur (112) servant à repousser une partie dudit second groupe d'électrons en direction dudit élément émetteur d'électrons.

8. Ioniseur (53) selon la revendication 7, dans lequel ledit réflecteur (112) est refroidi avec de l'eau.

9. Ioniseur (53) selon la revendication 7, dans lequel la décharge en arc entre le bouchon (118) et la paroi de la chambre d'ionisation (128) est utilisable pour fonctionner à un niveau de puissance d'environ 5 watts (W) et à un niveau de courant électrique d'environ 50 milliampères (mA).

10. Source d'ions (50), comprenant :
(i) un vaporisateur (51) comportant une cavité (66) servant à recevoir un matériau source (68) à vaporiser et à vaporiser le matériau source ;
(ii) un ioniseur (53) selon l'une quelconque des revendications 1 à 7 ; et
(iii) un milieu de chauffage (70) servant à chauffer au moins une partie dudit vaporisateur (51) et ledit tube d'alimentation (62).

11. Source d'ions (50) selon la revendication 10, comprenant en outre un mécanisme de commande pour réguler la température dudit milieu de chauffage (70).

12. Source d'ions (50) selon la revendication 10, dans lequel ledit élément émetteur d'énergie est un excitateur à radiofréquence (RF).

13. Source d'ions (50) selon la revendication 10, dans lequel ledit élément émetteur d'énergie est une source de micro-ondes.

14. Méthode de refroidissement d'un ioniseur pour implanteur, ledit ioniseur comprenant :
➢ un corps (96) comportant une entrée (119) vers un tube d'alimentation (62) afin de recevoir un matériau source vaporisé, ledit tube d'alimentation (62) étant doté d'un mécanisme de chauffage (90) permettant de chauffer le matériau source vaporisé lors de son passage à travers le corps (96) ;
➢ une chambre d'ionisation (108) dans laquelle le matériau source vaporisé est ionisé par un élément émetteur d'électrons (110) afin de créer un plasma ;
➢ une ouverture de sortie (126) pour extraire un faisceau d'ions composé dudit plasma ; et
➢ un mécanisme de refroidissement (100, 104) pour abaisser la température des parois (128) de ladite chambre d'ionisation (108) lors de l'ionisation dudit matériau vaporisé, ladite méthode comprenant l'étape suivante :
➢ la mise en circulation d'un fluide réfrigérant autour des parois de la chambre d'ionisation lors de l'ionisation du matériau vaporisé.

15. Méthode selon la revendication 14, dans laquelle lequel ledit mécanisme de refroidissement maintient lesdites parois (128) de ladite chambre d'ionisation (108) en dessous de 350°C pour éviter la dissociation des molécules de décaborane vaporisé.

16. Méthode selon la revendication 14, dans laquelle ladite ouverture (126) possède une taille permettant de fournier un courant de faisceau d'ions focalisés situés entre 100 microampères et 500 microampères (mu A) à une densité de courant de faisceau inférieure à 1 milliampère par centimètre carré (mA/cm²).

17. Méthode selon la revendication 14, dans laquelle ledit plasma présente une densité au sein de ladite chambre (108) de l'ordre de 10¹⁰/ cm³.
